## Europäisches Patentamt

## European Patent Office

## Office européen des brevets

(19)

(11) Numéro de publication: **0 195 707**
**B1**

(12)

# FASCICULE DE BREVET EUROPEEN

(45) Date de publication du fascicule du brevet:
26.09.90

(51) Int. Cl.⁵: **H01L 27/14**

(21) Numéro de dépôt: 86400452.8

(22) Date de dépôt: 04.03.86

(54) Procédé de fabrication d'une diode anti-éblouissement associée à un canal en surface, et système anti-éblouissement obtenu par ce procédé.

(30) Priorité: 08.03.85 FR 8503447

(43) Date de publication de la demande:
24.09.86 Bulletin 86/39

(45) Mention de la délivrance du brevet:
26.09.90 Bulletin 90/39

(84) Etats contractants désignés:
DE GB NL

(56) Documents cités:
FR-A- 2 199 200
US-A- 3 896 474
US-A- 4 173 064

IEEE TRANSACTIONS ON ELECTRON DEVICES, vol. ED-21, no. 6, juin 1974, pages 331-341, IEEE, New York, US; C.H. SEQUIN et al.: "Measurements on a charge-coupled area image sensor with blooming suppression"
PATENTS ABSTRACTS OF JAPAN, vol. 5, no. 121 (E-68) [793], 5 août 1981, page 30 E 68; & JP - A - 56 58 282 (TOKYO SHIBAURA DENKI K.K.) 21-05-1981
PATENTS ABSTRACTS OF JAPAN, vol. 7, no. 36 (E-158) [1181], 15 février 1983, page 148 E 158; & JP - A - 57 190 353 (FUJITSU K.K.) 22-11-1982

(73) Titulaire: THOMSON-CSF, 51, Esplanade du Général de Gaulle, F-92800 Puteaux(FR)

(72) Inventeur: Blanchard, Pierre, THOMSON-CSF
SCPI 19, avenue de Messine, F-75008 Paris(FR)

(74) Mandataire: Lincot, Georges et al, THOMSON-CSF SCPI,
F-92045 PARIS LA DEFENSE CEDEX 67(FR)

## Description

La présente invention concerne un procédé de fabrication d'une diode anti-éblouissement associée à un canal en surface et un système anti-éblouissement obtenu par ce procédé applicable notamment à la réalisation de matrices à transfert de trame et plus généralement à la réalisation de composants opto-électroniques.

Il est connue de réaliser des diodes anti-éblouissement sur les substrats semiconducteurs de matrices à transfert de trame à l'aide de procédés photolithographiques mettant en œuvre plusieurs photolithographies successives. Ces photolithographies permettent d'implanter des impuretés inverses au substrat pour créer sous des grilles des puits de potentiel supérieurs à ceux des parties non implantées, les zones non implantées portant généralement le nom de zones de canal en surface et les zones implantées portant le nom de zones de canal en volume. Selon ce procédé chaque diode est reliée à une grille en étant isolée de la partie de la zone canal de transfert en volume correspondante par une barrière de potentiel obtenue à partir d'une zone de canal en surface ce qui réalise une structure de transistors MOS, le sigle MOS étant l'abréviation du terme anglo-saxon "metal oxyde semiconductor", dont la source est formée par une diode classique et le drain est formé par une diode faiblement dopée dont le canal en surface est contrôlé par la grille.

Ce procédé présente l'inconvénient d'être mal adapté aux productions en série des matrices à transfert de trame car la précision du positionnement des zones de canal en surface et des zones de canal en volume dépend entièrement dans ce procédé de celle des machines photolithographiques, ce qui ne permet pas d'assurer une bonne reproductibilité des matrices à transfert de trame obtenues.

Le but de l'invention est de pallier les inconvénients précités.

A cet effet, l'invention a pour objet, un procédé de fabrication d'une diode anti-éblouissement associée à un canal en surface, consistant à déposer sur un substrat en silicium une couche d'un matériau diélectrique, puis à déposer sur cette couche une couche de silicium polycristallin non dopé, à graver par photolithogravure la couche de silicium polycristallin pour mettre à nu la couche diélectrique sur deux zones, une première zone définissant l'espace de formation de la diode, une deuxième zone définissant une zone de canal en volume, une troisième zone définissant le canal en surface étant protégée par le silicium polycristallin restant, à implanter des impuretés aussi bien dans la zone réservée à la diode que dans la zone canal de transfert en volume, à masquer la zone canal de transfert en volume en laissant découverte la zone réservée à la diode pour mettre à nu le substrat dans la zone réservée à la diode, à déposer une deuxième couche de silicium polycristallin sur l'ensemble formé par la partie mise à nu du substrat, la couche de silicium polycristallin et le diélectrique, à doper simultanément les deux couches de silicium polycristallin ce qui a pour effet de réaliser le dopage final désiré du substrat dans la zone définissant l'espace réservée à la diode et à graver la deuxième ou les deux couches de silicium polycristallin pour former la grille.

Le brevet US-A 4 173 064 divulgue un procédé de fabrication auto-aligné de diodes anti-éblouissement. L'implantation du canal de transfert en volume est effectuée dans une étape séparée après l'implantation des diodes. L'étape de dépôt d'une deuxième couche de silicium polycristallin déterminant le dopage final désiré des diodes n'existe pas dans ce procédé.

Le procédé selon l'invention a principalement pour avantage qu'il permet de définir à l'aide d'une seule photolithogravure en début du procédé la distance de la diode au canal de transfert en volume ainsi que la surface de celle-ci; de sorte que la reproductibilité du canal en surface et de la diode peut être aussurée. Cette solution permet également de choisir les dimensions minimales à donner tant en surface de diode qu'en largeur de canal pour réaliser les matrices à transfert de trame.

D'autres caractéristiques et avantages de l'invention apparaîtront à l'aide de la description faite au regard des dessins annexés donnés uniquement à titre d'exemple et dans lesquels:

– les figures 1 à 5 représentent les différentes phases du procédé selon l'invention;
– les figures 6A à 6C illustrent un procédé suivant l'art connue de réalisation d'une diode anti-éblouissement;
– la figure 7 est une représentation d'une réalisation d'une diode anti-éblouissement d'une matrice à transfert de trame suivant l'art connue;
– la figure 8 est une représentation d'un système anti-éblouissement d'une matrice à transfert de trame obtenue suivant le procédé de l'invention.

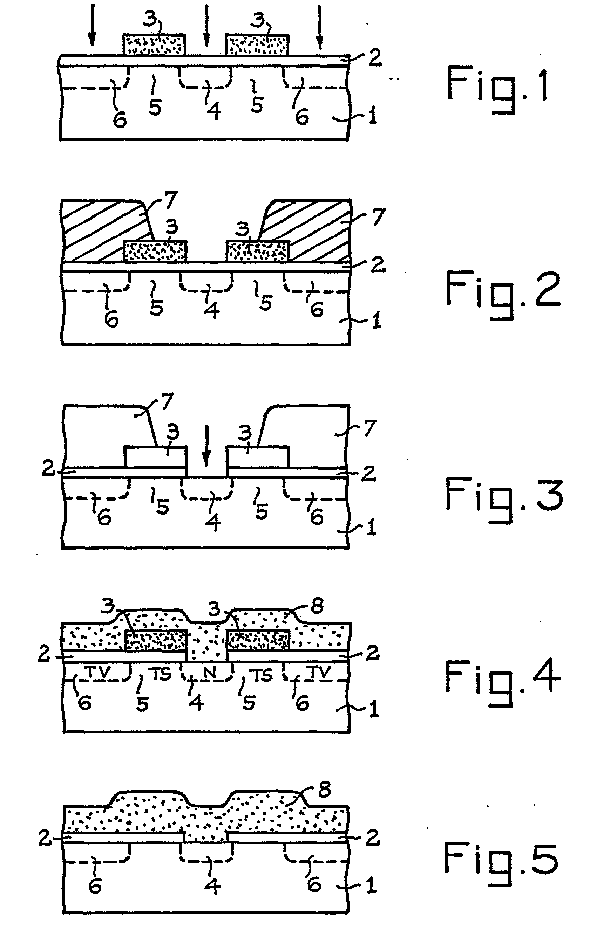

La première étape du procédé selon l'invention qui est représentée à la figure 1, consiste à déposer à la surface supérieure d'un substrat, 1, une couche d'un matériau diélectrique 2, puis à déposer au-dessus de la couche diélectrique 2 ainsi formée une couche de silicium polycristallin 3 non dopé. Une photolithogravure de la couche 3 de silicium polycristallin permet de définir des zones 4, 5, 6 délimitant respectivement l'espace réservé à la diode, la zone canal de transfert en surface et la zone canal de transfert en volume et d'implanter dans les zones 4 et 6 des impuretés. A l'étape représentée à la figure 2 le masquage des zones canal de transfert en volume est effectué par un masque 7 qui laisse à découvert la zone 4 réservée à la diode. A l'étape représentée à la figure 3, la mise à nu du substrat dans l'espace réservé à la diode 4 est effectuée puis, à l'étape représentée à la figure 4, une deuxième couche de silicium polycristallin 8 est déposée sur l'ensemble des premières couches de silicium et du diélectrique ou du substrat et les deux couches de silicium 3 et 8 sont dopées simultanément ce qui a pour effet de réaliser le dopage du substrat dans la zone 4 et la couche de silicium 8 ainsi réalisée. A l'étape représentée à la figure 5 une troisième photolithogravure est effectuée pour définir les grilles.

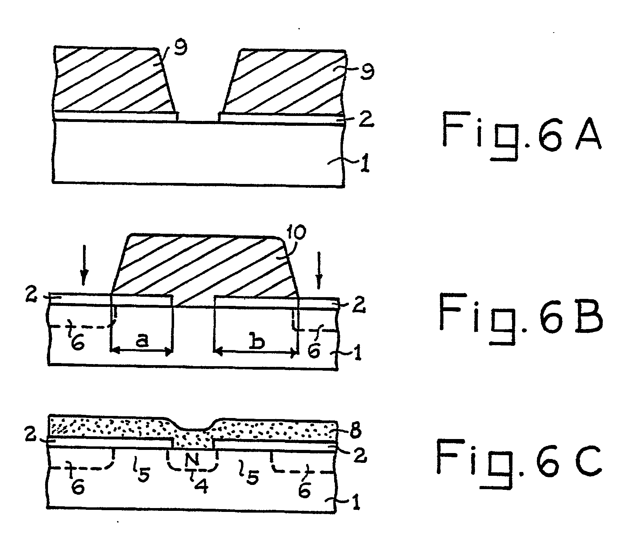

Contrairement aux procédés connus, le procédé selon l'invention permet de définir en une seule photolithogravure la distance de la diode au canal de
transfert en volume ainsi que la surface de la diode,
en effet, selon le procédé de l'art connu qui est représenté à l'aides des figures 6A, 6B et 6C la zone
4 réservée à la diode et la zone de canal en volume
6 sont obtenues en réalisant d'abord, comme ceci
est représenté à la figure 6A, une photolithogravure réalisée à l'aide d'un masque 9 appliqué sur la
surface de la couche diélectrique 2 pour délimiter la
zone réservée à la diode, puis à l'étape représentée à la figure 6B, une photolithographie pour réaliser une implantation dans la zone 6 définissant ainsi
la zone de canal en volume, la zone de canal en surface étant protégée par la résine du masque 10 et
enfin une troisième photolithogravure représentée
à la figure 6C pour réaliser la grille avec le silicium
déposé au-dessus de la zone réservée à la diode et
de la couche diélectrique 2. Selon ce procédé les
longueurs a, b de canal de transfert en surface séparant la zone réservée à la diode 4, des zones de
canal en volume 6, dépendent entièrement de la précision du masque 10 servant à la deuxième photolithographie représentée à la figure 6B. Avec le procédé selon l'invention la précision des zones de canal en surface est obtenue directement par la
première photolithogravure représentée à la figure
1 de sorte que, la reproductibilité du canal en surface entre la diode 4 et les zones de canal en volume
6 est toujours assurée.

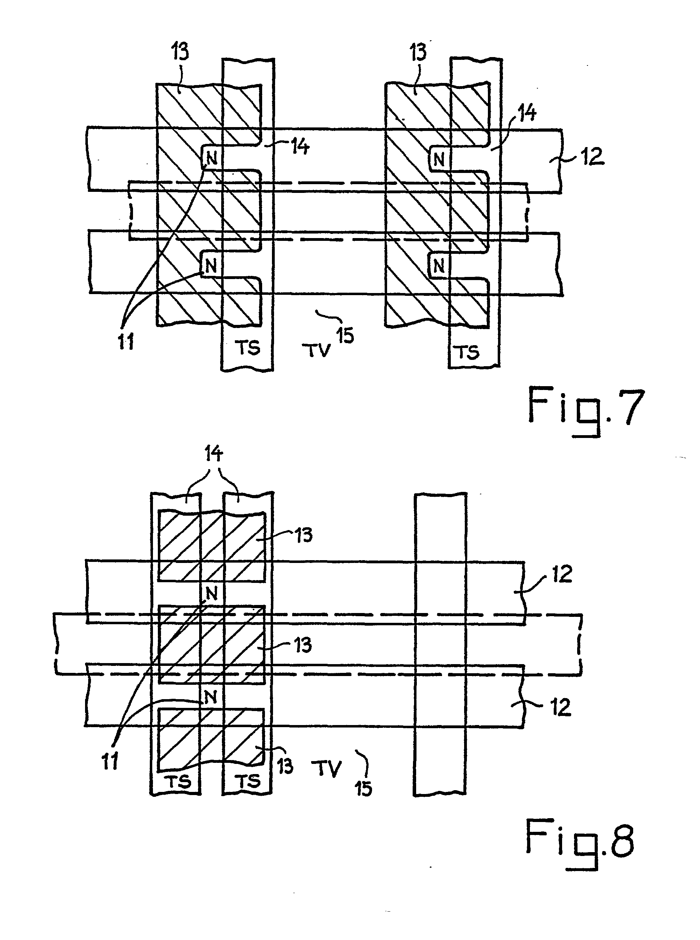

Un exemple d'application du procédé selon l'invention à la réalisation de matrices à transfert de
trame utilisant un système anti-éblouissement est
décrit ci-après à l'aide des figures 7 et 8. Dans les
systèmes anti-éblouissement des matrices à transfert de trame de l'art connu du type de celle qui est
représentée à la figure 7, chaque diode 11 est formée à partir de la grille 12 qui compose une partie du
pixel de la matrice à transfert de charge formant le
système. Une barrière de potentiel 14 due à la non-
implantation d'impuretés inverses au substrat forme
une zone qui isole la diode 11 des capacités réservoirs servant au transfert des charges et les charges en excès sont éliminées par la diode 11 ainsi formée et ceci de façon permanente. Si la longueur de
la barrière de potentiel est trop faible, il en résulte
un abaissement du niveau de potentiel qui peut conduire à une injection de charges de la diode 11 dans
le dispositif à transfert de charge. Le résultat de
cette saturation se traduit sur l'image obtenue par
des colonnes blanches. A l'inverse, si la longueur
de la barrière de potentiel est trop importante, la capacité de stockage est diminuée et par là même la dynamique du dispositif en est réduite.

L'emploi du nouveau procédé selon l'invention à
la réalisation d'une matrice du type représenté à la
figure 7, permet de garantir la distance de la diode 11
au canal en volume 15, mais la surface de la diode
dépend du positionnement de la photolithogravure
de la première couche de silicium par rapport à l'oxyde épais 13.

Une manière de remédier à cet inconvénient est
représentée à la figure 8. Selon le mode de réalisation représenté une même diode peut servir de dispositif anti-éblouissement pour deux pixels, une diode 11 disposée entre deux zones de canal en surface 14 et la couche épaisse d'oxyde délimite seulement deux côtés de la diode, la distance de la diode
au canal en volume ainsi que la surface de la diode
étant définies d'une part, par la photolitogravure de
la première couche de silicium et d'autre part, par la
couche d'oxyde épais 13.

## Revendications

Procédé de fabrication d'une diode anti-éblouissement associée à une grille à canal en surface
d'une matrice à transfert de trame, consistant à déposer sur un substrat en silicium (1) une couche (2)
d'un matériau diélectrique, puis à déposer sur cette
couche (2) une couche de silicium polycristallin (3)
non dopé à graver par une photolithogravure la
couche de silicium polycristallin (3) pour mettre à nu
la couche diélectrique (2) sur deux zones, une première zone (4) définissant l'espace de formation de
la diode, une deuxième zone (6) définissant une zone de canal en volume, une troisième zone (5) définissant le canal en surface étant protégée par le silicium polycristallin restant, à implanter des impuretés aussi bien dans la zone réservée à la diode (4)
que dans la zone canal de transfert en volume (6), à
masquer la zone canal de transfert en volume (6) en
laissant découverte la zone réservée à la diode (4)
pour mettre à nu le substrat dans la zone réservée
à la diode, à déposer une deuxième couche (8) de silicium polycristallin sur l'ensemble formé par la partie mise à nu du substrat, la couche de silicium polycristallin (3) et le diélectrique (2), à doper simultanément les deux couches de silicium polycristallin (3, 8)
ce qui a pour effet de réaliser le dopage final désiré
du substrat dans la zone (4) définissant l'espace réservé à la diode et à graver la deuxième ou les deux
couches (8 et 3) de silicium polycristallin pour former la grille.

## Claims

A method for the manufacture of glare-free diode associated with a channel gate in the surface of
a field transfer matrix consisting of placing on a silicon substrate (1) a layer (2) of a dielectric material,
then of placing on this layer (2) an undoped polycrystalline silicon layer (3), of photolithographically
etching the layer (3) polycrystalline silicon in order
to expose the dielectric layer (2) in two zones, the
first zone (4) defining the space for the formation
of the diode, a second zone (6) defining a volume
channel zone, a third zone (5) defining a surface
channel being protected by the remaining polycrystalline silicon, of implanting impurities both in
the zone reserved for the diode (4) and also in the
volume transfer channel (6), of masking the volume
transfer channel (6) while leaving uncovered the
zone reserved for the diode (4) in order to expose
the substrate in the zone reserved for the diode, of
placing a second polycrystalline silicon layer (8) on
the structure formed by the exposed part of the
substrate, the polycrystalline silicon layer (3) and
the dielectric (2), of simultaneously doping the two
polycrystalline silicon layers (3 and 8), this having the effect of performing the final desired doping of the substrate in the zone (4) defining the space reserved for the diode and of etching the second or the two layers (8 and 3) of polycrystalline silicon in order to form the gate.

**Patentansprüche**

Verfahren zur Herstellung einer Blendschutz-Diode, die einem Kanal-Gate an der Oberfläche einer Bildrasterüberführungsmatrix zugeordnet ist, welches darin besteht, auf einem Substrat (1) aus Silizium eine Schicht (2) auf einem dielektrischen Material aufzubringen, dann auf dieser Schicht (2) eine Schicht (3) aus nichtdotiertem, polykristallinem Silizium (3) aufzubringen, die Schicht (3) aus polykristallinem Silizium durch eine Photolithogravur einzugravieren, um die dielektrische Schicht (2) in zwei Zonen bloßzulegen, wobei eine erste Zone (4) den Raum für die Bildung der Diode begrenzt, eine zweite Zone (6) eine Volumen-Kanalzone begrenzt und eine dritte Zone (5), die den Oberflächen-Kanal abgrenzt, durch das übrige polykristalline Silizium geschützt ist, wobei das Verfahren ferner darin besteht, Verunreinigungen sowohl in der für die Diode reservierten Zone (4) als auch in der Volumen-Überführungs-Kanalzone (6) zu implantieren, die Volumen-Überführungs-Kanalzone (6) zu maskieren, wobei die für die Diode reservierte Zone (4) nicht bedeckt wird, um in der für die Diode reservierten Zone das Substrat bloßzulegen, eine zweite Schicht (8) aus polykristallinem Silizium auf die Einheit aufzubringen, welche aus dem bloßgelegten Teil des Substrats, der Schicht (3) aus polykristallinem Silizium und der dielektrischen Schicht (2) gebildet ist, die beiden Schichten (3, 8) aus polykristallinem Silizium gleichzeitig zu dotieren, was die Wirkung erzielt, die gewünschte Enddotierung des Substrats in der Zone (4) durchzuführen, die den für die Diode reservierten Raum begrenzt, sowie die zweite Schicht oder die beiden Schichten (8 und 3) aus polykristallinem Silizium einzugravieren, um das Gate zu bilden.

Fig.1

Fig.2

Fig.3

Fig.4

Fig.5

Fig. 6 A

Fig. 6 B

Fig. 6 C

Fig.7

Fig.8